# EUROPÄISCHE PATENTSCHRIFT

(11) **EP 1 807 372 B1**
(45) Veröffentlichungstag und Bekanntmachung des Hinweises auf die Patenterteilung: **27.07.2011**
(21) Anmeldenummer: 05803099.0
(22) Anmeldetag: 03.11.2005
(51) Int. Cl.: C03C 17/34, C23C 16/453, C03C 17/245, C03C 17/42, F24C 15/10

(54) **GLASKERAMIK-ARTIKEL MIT DIFFUSIONSBARRIERE UND VERFAHREN ZUR HERSTELLUNG EINES GLASKERAMIK-ARTIKELS MIT DIFFUSIONSBARRIERE**
GLASS CERAMIC ARTICLE HAVING A DIFFUSION BARRIER AND METHOD FOR PRODUCING A GLASS CERAMIC ARTICLE HAVING A DIFFUSION BARRIER
ARTICLE EN VITROCERAMIQUE COMPORTANT UNE BARRIERE DE DIFFUSION ET PROCEDE DE FABRICATION

(30) Priorität: 03.11.2004 DE 102004053707
(43) Veröffentlichungstag der Anmeldung: 18.07.2007
(73) Patentinhaber: Schott AG, 55122 Mainz (DE)
(72) Erfinder: HENZE, Inka, 55268 Nieder-Olm (DE); BUG, Michael, 64367 Mühltal (DE); HAHN, Gerhard, 55595 Allenfeld (DE); BECKER, Ottmar, 63225 Langen (DE); LUTHER, Veit, 65795 Hattersheim (DE)
(74) Vertreter: Herden, Andreas F.
(86) Internationale Anmeldenummer: PCT/EP2005/011760
(87) Internationale Veröffentlichungsnummer: WO 2006/048282

(56) Entgegenhaltungen:
- EP-A- 0 550 819
- EP-A- 0 716 270
- EP-A- 1 148 036
- DE-C1- 3 936 654
- DE-U1- 20 212 324

## Beschreibung

Die Erfindung betrifft allgemein die Herstellung von Glaskeramik-Artikeln, insbesondere betrifft die Erfindung Sperrschichten auf derartigen Artikeln.

Viele Glaskeramik-Artikel, wie zum Beispiel Glaskeramik-Kochflächen weisen Dekore auf. Bei einer Kochfläche können unter anderem kreisförmige Dekorierungen vorhanden sein, welche die Begrenzungen der einzelnen Kochfelder anzeigen. Auch werden vielfach Herstellerangaben aufgebracht.

Dekorfarben werden meist aus Kostengründen gleichzeitig mit Temperprozessen, wie insbesondere Vorspann- und/oder Keramisierungsprozessen auf den Glassubstraten eingebrannt. Bei einer Reihe von Dekorfarben kann es insbesondere während des Keramisierungsprozesses vom Glassubstrat zur Glaskeramik aber zu visuell störenden Oberflächeneffekten kommen. Bekannt sind diesbezüglich insbesondere blaue bis regenbogenfarbige Höfe oder Säume in der Dekor-Umgebung sowie durch Interferenzeffekte sichtbare Kontaktspuren während des Handlings oder der Lagerung. Unter anderem können Sauger- oder Papierabdrücke sichtbar bleiben.

In der DE 39 36 654 C1 wird ein Verfahren beschrieben, das einen hoffreien Dekoreinbrand während des Keramisierungsprozesses von LAS-Glaskeramiken beschreibt. Bei dem Verfahren wird vor der Dekorierung eine Siliziumoxid-Schicht, bevorzugt mit Hilfe eines Sprühverfahrens auf das Ausgangs-Substratglas aufgebracht.

Es hat sich dabei aber als nachteilig erwiesen, dass diese SiO₂-Schicht mit relativ grosser Dicke, ca. 100nm, aufgebracht werden muss, um wirksam das Entstehen von Höfen zu verhindern. Die grosse Dicke ist nötig, um die Eindiffusion von Dekorkomponenten wie zum Beispiel von Bor in das Grünglas zu verhindern. Ein weiterer Nachteil ist die Rissbildungsneigung von Sol-Gel-Schichten unter hohen Temperaturbedingungen und bei hohen Schichtdicken, die durch eine Nachvernetzung und einem daraus resultierenden Schrumpf der Schicht entsteht.

Aufgrund der Dicke der SiO₂-Schicht kommt es während des Keramisierungsprozesses außerdem zu unerwünschten Deformationen des Substrates. Die vergleichsweise starre SiO₂-Schicht auf der Oberseite führt dazu, dass durch die mit der Keramisierung verbundene Viskositätsabsenkung und durch den ebenfalls damit verbundenen Schrumpfprozess des Substrates, das Substrat domförmig deformiert wird.

Die EP-A- 0 550 819 beschreibt ein Verfahren, bei dem auf dem Glaskeramik - artikel nach dem Einbrennen der Glaskeramikfarbe eine SiO₂ - Schicht aufgebracht wird.

Ferner wird in der EP 1 148 036 A1 ein Verfahren zum Modifizieren einer Oberfläche eines kompakten Substrats beschrieben, bei dem die Oberfläche mit einer oxidierenden und einer silikatisierenden Flamme behandelt wird. Dieses Verfahren, bei dem in einer Ausgestaltung auf die Oberfläche eine Druckfarbe etwa in Form eines Siebdruck-, Flachdruck-, oder Offset- und auch Tiefdruckverfahren aufgebracht wird, dient einer Bereitstellung von amorphen Oberflächen kompakter Substrate. Dabei werden homogenisierte Oberflächen mit einer hohen Dichte an reaktiven OH-Gruppen erzeugt. Bei dem Verfahren wird in einem ersten Verfahrensschritt durch Einsatz einer oxidierenden Flamme Feuchtigkeit in nicht homogenen Gelschichten, die an amorphen Oberflächen kompakter Substrate auftreten, reduziert. In einem zweiten Behandlungsschritt wird unter Einsatz einer silikatisierenden Flamme eine Silikatschicht bzw. Siliziumoxid-Schicht mit submikroskopischer Rauhigkeit aufgebracht.

Eine Druckfarbe kann auf diese Schicht unter Einsatz verschiedenster Drucktechniken aufgebracht werden. In einer Ausführung des Verfahrens wird eine silikatisierende Flamme und über eine Flammpyrolyse eine SiOₓ -Beschichtung auf der Oberfläche des zu beschichtenden Substrats erzeugt.

Die EP 1 148 036 A1 beschreibt aber die Rauhigkeit der Schicht als im submikroskopischen Bereich liegend. Daher erscheint eine Kombination der flammpyrolytischen Schichterzeugung mit der nach dem Sol-Gelverfahren arbeitenden Beschichtungsart gemäß der DE 39 36 654 C1 nicht zur Lösung der mit dieser verbundenen Probleme geeignet.

Der Erfindung liegt demgemäß die Aufgabe zugrunde, verbesserte Glaskeramik-Substrate mit Dekor bereitzustellen. Diese Aufgabe wird bereits in höchst überraschend einfacher Weise durch ein Verfahren und ein Glaskeramik-Substrat gemäß den unabhängigen Ansprüchen gelöst. Vorteilhafte Weiterbildungen und Ausgestaltungen der Erfindung sind in den Unteransprüchen angegeben.

Diese Aufgabe wird durch den Gegenstand der Ansprüche 1, 2, 21, 22, 27 und 28 gelöst.

Demgemäß sieht die Erfindung ein Verfahren zur Herstellung eines dekorierten Glaskeramik-Substrats, bei welchem ein Glassubstrat hergestellt oder bereitgestellt, auf dem Substrat eine Siliziumoxid-haltige Schicht abgeschieden, auf der Siliziumoxid-haltigen Schicht Dekorfarbe aufgebracht, ein Dekor durch Einbrennen der Dekorfarbe hergestellt und das Glassubstrat keramisiert wird, wobei die Siliziumoxid-haltige Schicht durch Überstreichen zumindest eines Bereiches der Oberfläche des Substrats mit einer Flamme und Hydrolyse einer der Flamme zugesetzten Siliziumverbindung flammpyrolytisch abgeschieden wird. Ein erfindungsgemäß herstellbares Glaskeramiksubstrat, ist dementsprechend mit einem Dekor aus eingebrannter Dekorfarbe ausgestattet -, wobei das Dekor auf einer flammpyrolytischen Siliziumoxid-haltigen Schicht auf dem Substrat aufgebracht ist.

Ebenfalls möglich ist es, das Dekor vor dem Abscheiden der Siliziumoxid-haltigen Schicht aufzubringen und dann die Siliziumoxid-haltige Schicht auf dem Substrat abzuscheiden, so daß die Dekorfarbe und nicht dekorierte Bereiche der Oberfläche von der Siliziumoxid-haltigen Schicht bedeckt werden. Demgemäß wird bei einem Verfahren zur Herstellung eines dekorierten oder Glaskeramik-Substrats gemäß dieser. Ausführungsform der Erfindung ein Glassubstrat hergestellt oder bereitgestellt, auf dem Substrat Dekorfarbe aufgebracht, auf der mit dem Dekor versehenen Oberfläche eine Siliziumoxid-haltige Schicht abgeschieden, die Dekorfarbe eingebrannt und das Glassubstrat keramisiert, wobei die Siliziumoxid-haltige Schicht durch Überstreichen zumindest eines Bereiches der Oberfläche des Substrats mit einer Flamme und Hydrolyse einer der Flamme zugesetzten Siliziumverbindung flammpyrolytisch abgeschieden wird.

In beiden Fällen -Abscheidung der Siliziumoxid-haltigen Schicht vor oder nach Auftrag der Dekorfarbe- ist ein erfindungsgemäß hergestelltes Glaskeramiksubstrat mit einem Dekor aus eingebrannter Dekorfarbe ausgestattet, wobei das Dekor von mit einer flammpyrolytischen Siliziumoxid-haltigen Schicht bedeckten Bereichen der Substratoberfläche umgeben ist. Auf diese Weise wird eine Hofbildung wirksam vermieden.

Durch die vorliegend beschriebene Erfindung kann unter anderem eine Deformation von Substraten, wie sie bei dem in der DE 3936654 C1 beschriebenen Verfahren auftritt, vermieden werden, da sich in überraschender Weise herausgestellt hat, dass SiO₂-Schichten, die mit dem erfindungsgemäßen flammpyrolytischen Verfahren hergestellt werden, deutlich dünner sein können.

So hat sich überraschend gezeigt, daß eine Abscheidung einer Siliziumoxid-haltigen Schicht mit einer Schichtdicke von 1 bis 100 Nanometern, besonders bevorzugt 4 bis 40 Nanometern, besonders bevorzugt auch von höchstens 20 Nanometern bereits ausreichend ist, um als Diffusionsbarriere eine Diffusion von Komponenten aus dem oder in das Substrat zu unterdrücken. Damit wird bei derartig dünnen Schichten bereits wirksam eine Hofbildung am Dekor unterdrückt. Bei dieser geringen Dicke wird die oben beschriebene Deformation des Substrates während des Keramisierungsprozesses nicht mehr beobachtet. Dieser überraschende Effekt ist auch auf die sehr dichte Struktur und den dadurch bewirkten verbesserten Barriereeffekt derartiger flammpyrolytischer Silikat-haltiger Schichten zurückzuführen. Auf Grund der geringen Dicke ist die Schicht auch visuell unwirksam, beziehungsweise unsichtbar, so daß eine wie in DE 3936654 C1 beschriebene Brechwertanpassung durch TiO₂-Dotierung nicht notwendig ist.

Das Abscheiden der Siliziumoxid-haltigen Schicht kann dabei sowohl vor, als auch nach der Keramisierung erfolgen. Wird die Siliziumoxid-haltige Schicht nach der bereits erfolgten Keramisierung abgeschieden, so erfolgt ein gesonderter Dekoreinbrand auf dem Glaskeramik-Substrat.

Eine bevorzugte Ausführungsform des Verfahrens betrifft das Herstellen von Glaskermik-Gegenständen, wobei in vorteilhafter Weise das Einbrennen des Dekors gleichzeitig durch ein Keramisieren des Substrats erfolgt. Dabei wird dementsprechend die Siliziumoxid-haltige Schicht vor dem Keramisieren aufgebracht. Das auf diese Weise erhaltenen Zwischenprodukt zur Herstellung eines Glaskeramik-Artikels, also ein Grünglas-Substrat mit einer darauf abgeschiedenen Siliziumoxid-haltigen flammpyrolytischen Beschichtung zeigt außerdem die überraschende Eigenschaft, daß die flammpyrolytische Siliziumoxid-haltige Schicht als Gleitschicht wirkt, welche das Entstehen von Kratzern und anderen oberflächlichen Beschädigungen bei der Weiterbehandlung vermeiden oder abmildern kann.

Die Schicht kann neben der Barrierewirkung dementsprechend auch noch zusätzliche Funktionen haben. Durch eine Beschichtung mit Siliziumoxid-haltigen Schichten können - wie im vorstehenden Beispiel des flammpyrolytisch beschichteten Grünglas-, beziehungsweise Ausgangsglas-Substrats- Schutzwirkungen beispielsweise gegen Verkratzen der Glas- und Glaskeramiksubstrate erzielt werden. Außerdem können mögliche Probleme, die im Keramisierungsprozess auftreten können, wie beispielsweise Schrumpf-Kratzer bei der Keramisierung und/oder Anhaften auf einer Transportunterlage verhindert oder verringert werden. Geeignete Substrate sind unter anderem Scheiben aus Floatglas oder gewalztem Glas oder aus diesen Materialien hergestellte Glaskeramik. Zur Herstellung von erfindungsgemäßen dekorierten Glaskeramik-Erzeugnissen können solche Substrate auch als Ausgangssubstrate, beziehungsweise als Grünglas verwendet werden. Derartige flache Substrate, wie sie unter anderem durch Floaten oder Walzen erhalten werden, können gemäß einer Weiterbildung der Erfindung auch beidseitig flammpyrolytisch beschichtet werden. Die beidseitige flammpyrolytische Beschichtung kann dann als Grundlage für ein beidseitiges Dekor durch beidseitigen Auftrag der Dekorfarbe und Einbrennen erfolgen.

Wird ein Floatglas oder Walzglas oder eine daraus hergestellte Glaskeramik als Substrat verwendet, umfaßt das Herstellen des Glassubstrats das Herstellen eines bevorzugt kontinuierlichen Glasbandes durch Floaten und/oder Walzen. Das Abscheiden der Siliziumoxid-haltigen Schicht kann gemäß einer Ausführungsform der Erfindung nach dem Walzen oder Floaten bereits auf dem kontinuierlichen Glasband geschehen. Das Herstellen des Substrats kann weiterhin auch das Abtrennen eines Abschnitts vom kontinuierlich hergestellten Glasband umfassen. Hierbei besteht auch die Möglichkeit, die Siliziumoxid-haltige Schicht erst auf dem bereits vereinzelten, durch Abtrennen eines Abschnitts vom Glasband hergestellten Substrat aufzubringen. Diese Weiterbildung der Erfindung ist unter anderem vorteilhaft, wenn sich an das Abtrennen des Substrats weitere Verarbeitungsschritte anschließen, welche die flammpyrolytische Beschichtung wieder beschädigen können. Dies können unter anderem Heißformungsschritte zur Herstellung gewölbter Substrate sein. Auch erlaubt die Beschichtung nach dem Vereinzeln mehrere Produktlinien herzustellen. Dies ist beispielsweise dann von Vorteil, wenn auch Erzeugnisse ohne Dekoreinbrand aus dem Glasband hergestellt werden sollen.

Der Auftrag der Dekorfarbe kann mit einem beliebigen Verfahren erfolgen, mit dem ein strukturierter Auftrag zur Erzeugung des Dekormusters möglich ist. Eine Möglichkeit ist beispielsweise das Aufdrucken. Insbesondere der Siebdruck, mit welchem auch pastöse Farben ohne weiteres aufgebracht werden können, ist geeignet. Auch elektrostatischer und/oder elektrophotographischer Auftrag, Übertragung eines Abziehbildes, Aufsprühen oder Aufspritzen können zum Auftrag der Dekorfarbe verwendet werden.

Als Siliziumverbindung kann der Flamme zur Abscheidung der Siliziumoxid-haltigen Schicht zumindest eine der Substanzen Hexamethyldisiloxan (HMDSO), Hexamethyldisilazan (HMDSN), Tetraethoxysilan zugeführt werden. Als Brenngas kann weiterhin bevorzugt ein Gas mit zumindest einer der Komponenten Wasserstoff, Methan, Propan, Butan verwendet werden.

Für die Qualität der flammpyrolytischen Beschichtung hat es sich insbesondere auch als günstig erwiesen, eine Flamme mit einem oxidierenden und einem reduzierenden Teil zu erzeugen und das Substrat zur Abscheidung der Siliziumoxid-haltigen Schicht nur mit dem oxidierenden Teil zu überstreichen. Damit wird unter anderem eine Abscheidung von nur teilhydrolysierten Siliziumverbindungen oder eine Verunreinigung mit Brenngas-Bestandteilen weitgehend vermieden.

Die erfindungsgemäße flammpyrolytische Beschichtung weist noch weitere Vorzüge auf. Die Schicht ist nicht nur in der Lage, eine wirksame Diffusionsbarriere gegen eine Hofbildung in der Umgebung des Dekors, gegen Kontaktartefakte, sowie unerwünschte Aufwölbungen der Substrate bei Temperprozessen zu vermeiden. Die im wesentlichen Siliziumdioxid enthaltende Schicht weist außerdem auch -bedingt durch den Hydrolysevorgang-Hydroxylgruppen auf, die insbesondere auch an der Oberfläche der Schicht vorhanden sind. Diese OH-Gruppen bewirken eine besonders gute Anbindung und damit wesentlich verbesserte Anhaftung darauf aufgebrachter Schichten. Dies gilt insbesondere für die Haftung des Dekors. Es können aber auch zusätzlich andere funktionelle Schichten aufgebracht werden, deren Haftung und Haltbarkeit wesentlich verbessert wird ,z.B. elektrisch leitfähige Schichten, leicht reinigbare oder harte Schichten.

Weiterhin zeigt sich, daß mit der flammpyrolytischen Abscheidung eine körnige Oberflächenstruktur der Siliziumoxid-haltigen Schicht mit Siliziumoxid- oder siliziumoxid-haltigen Körnern mit einem in Aufsicht betrachteten Durchmesser bis höchstens 80 Nanometer, vorzugsweise bis höchstens 60 Nanometer erzeugt wird . Dabei sind die Körner auf der Oberfläche einer dichten flammpyrolytischen Schicht angeordnet. Bei einer solchen Schicht wird als Schichtdicke die Schichtdicke der dichten Schicht ohne den darauf angeordneten Körnern verstanden.

Es wird nicht ausgeschlossen, daß sich auch einzelne Körner mit noch größeren Durchmessern auf der Oberfläche finden. Beispielsweise kann es zu einer Agglomeration mehrerer Körner kommen, welche im Mikroskop dann wie ein einzelnes Korn erscheinen können. Jedenfalls weisen bei erfindungsgemäßen Schichten mehr als 90% der bei 200000-facher Vergrößerung im Rasterelektronenmikroskop erkennbaren einzelnen Körner einen Durchmesser bis höchstens 80 Nanometer, vorzugsweise bis höchstens 60 Nanometer auf. Auch können sich größere Körner mit größerem Durchmesser erkennbar aus solchen kleineren, agglomerierten Körnern zusammensetzen. Im allgemeinen weisen die Körner überwiegend Durchmesser bis 40 Nanometer auf.

Derartige Siliziumoxid-haltige Schichten auf einem Glaskeramik-Substrat ermöglichen eine besonders gut haftende Beschichtung mit weiteren Schichten, da durch die körnige Struktur der erfindungsgemäße abgeschiedenen Schicht eine sehr große Oberfläche erreicht werden kann. Außerdem kann die Empfindlichkeit gegen ein Verkratzen herabgesetzt werden. Trotz der körnigen Oberfläche wird dennoch aufgrund der dichten Schicht, auf der die Körner angeordnet sind, eine ausreichende Barrierewirkung bewirkt, um eine ansonsten beim Dekoreinbrand auftretende Hofbildung zu vermeiden. Nach der Keramisierung kann es dann zu einer Glättung der körnigen Oberflächenstruktur kommen. Dabei können sich aus den Körnern wellige Strukturen ausbilden.

Eine Weiterbildung der Erfindung sieht vor, daß ein Teilbereich der Siliziumoxid-haltigen Schicht mit einer hydrophoben Beschichtung beschichtet wird. Eine solche Schicht kann vorteilhaft eine Sol-Gel-Schicht mit einer hydrophoben Komponente umfassen. Insbesondere ist dabei an eine Silikatschicht gedacht, die durch Sol-Gel-Beschichtung herstellbar ist. Als hydrophobe Komponenten eignet sich besonders ein Fluoralkylsilan.

Auch kann das Substrat zusätzlich zur Dekorschicht mit einer infrarotreflektierenden Schicht beschichtet werden. Geeignet hierzu ist besonders eine Zinnoxidschicht. Einer solchen Schicht kann die flammpyrolytische Siliziumoxid-haltige Schicht auch auf der Zinnoxidschicht aufgebracht werden, um als Haftvermittler für das Dekor und/oder eine andere Beschichtung zu wirken, da die Haftung einer weiteren Schicht auf einer Zinnoxidschicht vielfach nur schlecht ist. Demgegenüber hat sich überraschend gezeigt, daß eine erfindungsgemäße flammpyrolytische Siliziumoxid-haltige Schicht auch auf Zinnoxid sehr gut anhaftet. Neben einer Verwendung als infrarotreflektierende Schicht kann Zinnoxid auch als transparente, leitfähige Schicht eingesetzt werden. Insbesondere ist Fluor-dotiertes Zinnoxid als derartige Schicht geeignet.

Die Erfindung, mit welcher besonders haltbare Dekore ohne Verwölbung aufgebracht werden können, eignet sich dementsprechend beispielsweise hervorragend zur Herstellung von Artikeln für Haushaltsgeräte aus Glaskeramik, wie Kochflächen, Backofenscheiben, Back-, Koch- oder Gargefäße, beispielsweise einem glaskeramischen Wok.

Die Erfindung eignet ebenfalls sich als Barrierebeschichtung gegenüber aus Brenngasen entstehenden aggressiven Medien und/oder anderen Verdampfungskomponenten und oder Kontaminationen aus der Temperumgebungen, die z.B. das Glas oder die Glaskeramik korrodieren können. Die Erfindung ist dementsprechend unter anderem auch - unabhängig davon, ob ein Dekor aufgebracht wirdhervorragend geeignet für Glaskeramik-Reflektoren oder als Beschichtung von Glaskeramik-Artikeln, welche aggressiven Verbrennungsprodukten ausgesetzt sind, beispielsweise gasbeheizten Glaskeramik-Kochflächen oder Sichtscheiben, unter anderem Kamin- Brenner- oder Ofensichtscheiben. So sieht die Erfindung auch ein Verfahren zur Herstellung eines Glaskeramik-Reflektors vor, bei welchem eine Glaskalotte für einen Reflektor bereitgestellt und keramisiert wird, wobei in analoger Weise wie bei den vorstehend beschriebenen Ausführungsformen der Erfindung auf der Kalotte eine Siliziumoxid-haltige Schicht durch Überstreichen zumindest eines Bereiches der Oberfläche der Kalotte mit einer Flamme und Hydrolyse einer der Flamme zugesetzten Siliziumverbindung flammpyrolytisch abgeschieden wird. Die Siliziumoxid-haltige Schicht kann vorteilhaft auch wieder als Grundlage für ein aufgebrachtes Dekor, wie zum Beispiel einem Herstellerlogo verwendet werden. Weiterhin kann das Abscheiden der Siliziumoxid-haltigen Schicht sowohl vor, als auch nach der Keramisierung der Kalotte vorgenommen werden. Wird die Siliziumoxid-haltige Schicht nach der Keramisierung abgeschieden, so kann diese Schicht auch auf vorher abgeschiedene weitere Schichten aufgebracht werden. Hierbei ist insbesondere auch an die ein- oder mehrlagige Reflexionsbeschichtung der Kalotte gedacht.

Ebenso können schädliche Langzeitwirkungen durch die Gasbeflammung oder Verbrennungsprodukte bei Glaskeramik-Artikeln wie Glaskeramik-Kochfeldern oder glaskeramischen Feuerschutzgläsern, beispielsweise Kamin- Brenner- oder Ofensichtscheiben vermieden oder zumindest vermindert werden, indem auf zumindest einer Seite des Substrats des Artikels oder des Grünglas-Substrats eine Siliziumoxid-haltige Barriereschicht durch Überstreichen mit einer Flamme und Hydrolyse einer der Flamme zugesetzten Siliziumverbindung flammpyrolytisch abgeschieden wird. Als Grünglas-Substrat wird im Sinne der Erfindung das Glassubstrat vor der Keramisierung bezeichnet. Die flammpyrolytische Siliziumoxid-haltige Schicht wirkt auch hier als Diffusionsbarriere, welche das Eindringen von Verbrennungsrückständen in das keramisierte Substrat verhindert oder wenigstens verlangsamt. So zeigt sich bei glaskeramischen Sichtscheiben für Brenner, Öfen oder Kamine, daß diese Scheiben im Laufe der Zeit stark durch entstehende Schwefeloxide angegriffen werden. Auch bei derartigen Glaskeramik-Artikeln kann die flammpyrolytische Abscheidung der Siliziumoxid-haltigen Schicht vor oder nach der Keramisierung durchgeführt werden. Auch können diese Artikel ebenfalls, wie oben beschrieben, mit einem Dekor ausgestattet werden.

Im folgenden wird die Erfindung anhand von Ausführungsbeispielen und unter Bezugnahme auf die Zeichnungen näher erläutert, wobei gleiche und ähnliche Elemente mit gleichen Bezugszeichen versehen sind und die Merkmale verschiedener Ausführungsbeispiele miteinander kombiniert werden können.

Es zeigen:
- Fig. 1A bis 1C: Verfahrensschritte zur Herstellung eines dekorierten Glaskeramik-Substrats gemäß einer ersten Ausführungsform der Erfindung,
- Fig. 2: eine Vorrichtung zur Durchführung einer Variante des anhand der Fig. 1A bis 1C gezeigten Verfahrensschritte,
- Fig. 3: eine Ausführungsform eines erfindungsgemäß herstellbaren Substrats mit infrarotreflektierender und hydrophober, oder elektrisch leitfähiger Beschichtung,
- Fig. 4 bis 7: Verwendungsbeispiele für ein erfindungsgemäßes beschichtetes Substrat,
- Fig. 8 und 9: rasterelektronenmikroskopische Aufnahmen einer flammpyrolytischen Schicht, und
- Fig. 10: eine rasterelektronenmikroskopische Aufnahme eines Glaskeramik-Substrats mit einer flammpyrolytischen Schicht nach der Keramisierung.

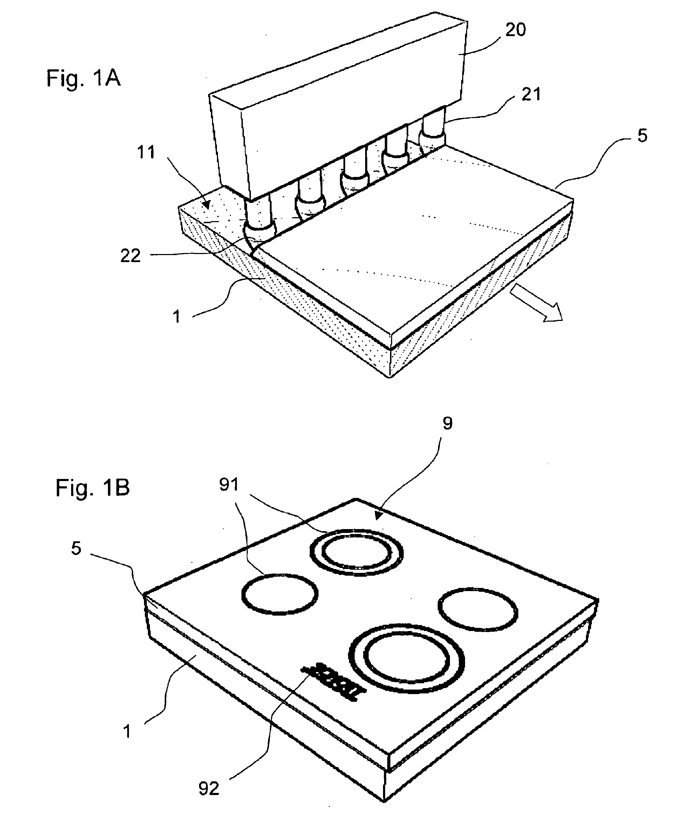

Anhand der Fig. 1A bis 1C werden Verfahrensschritte zur Herstellung eines dekorierten Glaskeramiksubstrats gemäß einer ersten Ausführungsform der Erfindung erläutert.

Das Verfahren zur Herstellung eines dekorierten Glaskeramik-Substrats basiert darauf, ein Glassubstrat herzustellen oder bereitzustellen, auf dem Glassubstrat eine Siliziumoxid-haltige Schicht durch Überstreichen zumindest eines Bereiches der Oberfläche des Substrats mit einer Flamme und Hydrolyse einer der Flamme zugesetzten Siliziumverbindung flammpyrolytisch abzuscheiden, auf der Siliziumoxid-haltigen Schicht Dekorfarbe aufzubringen und das Dekor daraufhin einzubrennen.

Fig. 1A zeigt den Schritt des Abscheidens der Siliziumoxid-haltigen Schicht. Zunächst wird ein flaches, scheibenförmiges Substrat bereitgestellt. Als Substrat 1 kann dazu insbesondere eine Glasscheibe aus Floatglas, gewalztem Glas oder daraus hergestellter Glaskeramik verwendet werden, welche durch Abtrennen eines Abschnitts von einem kontinuierlich hergestellten gefloateten und/oder gewalzten Glasband hergestellt wird.

Zur Abscheidung der Siliziumoxid-haltigen Schicht 5 wird die Seite 11 des in diesem Beispiel flachen, scheibenförmigen Substrats 1 dann mit Flammen 21 überstrichen, indem das Substrat 1 an einer Brennerbatterie 20 mit Brennern 21, welche die Flammen 22 erzeugen, vorbeigeführt wird. Selbstverständlich ist es auch möglich, anstelle oder zusätzlich zur Bewegung des Substrats 1 die Brennerbatterie 20 zu bewegen. Durch die Hydrolyse einer der Flamme zugeführten Siliziumverbindung wird auf dem Substrat dann die Siliziumoxid-haltige Schicht 5 abgeschieden. Als Siliziumverbindung kann insbesondere Hexamethyldisiloxan (HMDSO), Hexamethyldisilazan (HMDSN) und/oder Tetraethoxysilan der Flamme zugeführt werden. Im einfachsten Fall wird dazu die Siliziumverbindung in gasförmiger Form dem Brenngas beigemischt. Als Brenngas wird bevorzugt ein Gas mit einer oder mehreren der Komponenten Wasserstoff, Methan, Propan, Butan eingesetzt.

Die für die Schichtdicke der Schicht 5 relevanten Beschichtungsparameter, wie unter anderem die Zusammensetzung des Brenngases mit Siliziumverbindung und die Geschwindigkeit des Vorbeiführens des Substrats 1 an den Flammen 22 werden so eingestellt, daß die Siliziumoxid-haltige Schicht eine Schichtdicke von 1 bis 100 Nanometern, bevorzugt 4 bis 40 Nanometern, besonders bevorzugt höchstens 20 Nanometern aufweist.

Wird als Substrat 1 ein Grünglas-Substrat zur Herstellung eines Glaskeramik-Artikels beschichtet, so wird mit dem in Fig. 1A gezeigten Verarbeitungsschritt ein Zwischenprodukt mit einer auf dem Grünglas-Substrat abgeschiedenen flammpyrolytischen Siliziumoxid-haltigen Schicht hergestellt, welches durch die flammpyrolytische Schicht außerdem durch die Schicht 5 einen gewissen Schutz gegen Beschädigungen bei der weiteren Behandlung erhält. So können Kratzer, die bei der Weiterbehandlung, beispielsweise dem Transport auf Rollen oder dem Auflegen und Abheben des Substrats auf Unterlagen entstehen können, durch die glattere Oberfläche und die größere Härte der Schicht 5 zu einem gewissen Grade vermieden werden.

Fig. 1B zeigt das Substrat nach dem strukturierten Auftragen von keramischer Dekorfarbe 9 auf die Silizumoxidhaltige Schicht 5. Das Dekormuster umfaßt in diesem Beispiel Muster in Form von kreisförmigen Kochfeldbegrenzungen 91 und einem Herstellerlogo 92. Der Auftrag der Dekorfarbe 9 mit den Mustern 91, 92 kann beispielsweise durch Siebdruck, elektrostatischem Auftrag, insbesondere elektrophotographischem Auftrag, Übertragung eines Abziehbildes, Aufsprühen oder Aufspritzen erfolgen.

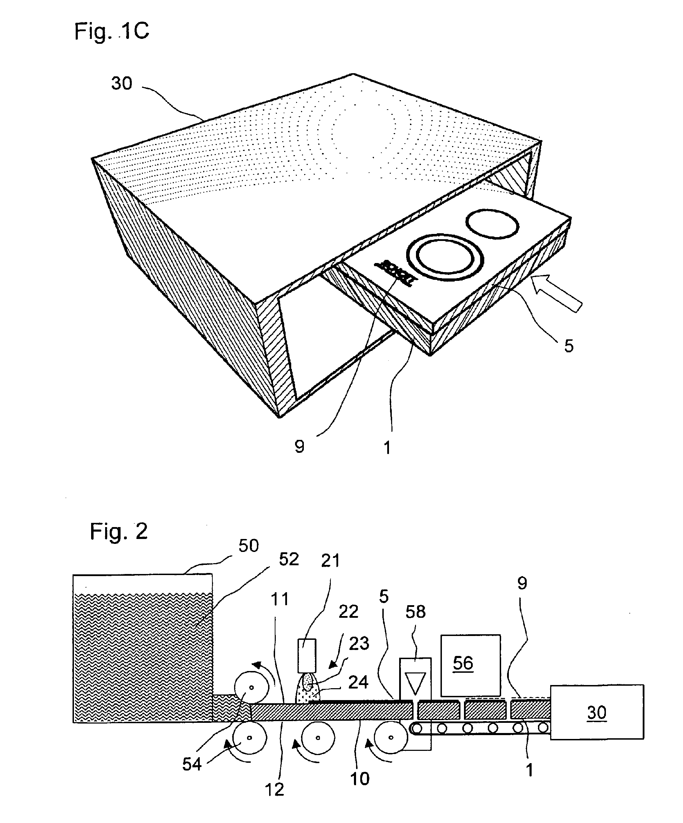

Anschließend wird die keramische Dekorfarbe eingebrannt. Diesen Schritt zeigt Fig. 1C. Bei dieser Ausführungsform des erfindungsgemäßen Verfahrens erfolgt der Dekoreinbrand insbesondere gleichzeitig mit einer Keramisierung des Glassubstrats 1, wobei eine dekorierte Glaskeramikplatte erhalten wird.

Für die Keramisierung und den gleichzeitigen Dekoreinbrand wird dazu das mit der Schicht 5 und der darauf aufgetragenen Dekorfarbe in einen Keramisierungsofen 30 eingeschoben. Beim Keramisieren im Ofen 30 wird das Glassubstrat 1 dabei so weich, daß bereits geringe auf das Substrat 1 wirkende Kräfte zu unerwünschten Verformungen führen. So können bei der Keramisierung bei typischerweise 900 °C oder darüber Viskositäten unter η=10¹¹ dPa·s erreicht werden. Während der Keramisierung, kommt es außerdem zur Schrumpfung des Substrats. Die flammpyrolytisch abgeschiedene Schicht 5 verursacht dabei im Unterschied etwa zu dickeren Sol-Gel-Schichten, wie sie mit dem aus der DE 3936654 C1 bekannten Verfahren erhalten werden, keine relevanten thermischen Spannungen, so daß eine Verformung vermieden wird. Die silikatische Schicht 5 mit der hohen Dichte terminaler OH-Gruppen sorgt außerdem für eine verbesserte Haftung des Dekors nach dem Einbrand, beziehungsweise der Keramisierung.

Beim Keramisieren wird das Grünglas-Substrat üblicherweise auf einer Unterlage, typischerweise ein Keramikträger aufgelegt und keramisiert. Das Grünglas-Substrat wird bei der Keramisierung sehr weich und schrumpft. Aufgrund der niedrigen Viskosität beim Keramisieren kann es zu einem Ankleben des Glases an der Unterlage kommen, wobei sich das Glas beim Schrumpfen wieder ablöst, so daß unschöne Oberflächenbeschädigungen, wie Kratzer und Löcher in der Oberfläche entstehen können. Wird aber erfindungsgemäß eine Siliziumoxid-haltige Schicht 5 vor der Keramisierung auf der bei der Keramisierung aufliegenden Seite aufgebracht, so kann ein Ankleben auf der Unterlage und damit verbundene Beschädigungen vermieden werden. Die Schicht 5 kann überdies auch in gewissem Maße vor anderen Beschädigungen schützen, welche bedingt durch die Herstellung, den Vertrieb und die Verwendung von Erzeugnissen mit derartigen Glas- oder Glaskeramikgegenständen auftreten können. Beispielsweise kann dazu, anders als in Fig. 1C dargestellt, auch beidseitig eine flammpyrolytische, Siliziumoxid-haltige Schicht aufgebracht sein.

Ist eine Schicht 5 -unabhängig davon, ob ein Dekor aufgebracht wird oder nicht- auf einer oder beiden Seiten des Substrats 1 aufgebracht, so kann das Substrat 1 auch besonders vorteilhaft als Glaskeramik-Kochfeld für Gasbeheizung oder als Glaskeramik-sichtscheibe, beispielsweise als Kamin- Ofen- oder Gasbrenner-Sichtscheibe verwendet werden. Die Schicht 5 wirkt dann als Barrierebeschichtung gegen eindringende Verbrennungsrückstände. Unter anderem entfaltet Schwefeldioxid als typisches Verbrennungsprodukt korrodierende Wirkung auf die Glaskeramik.

Fig. 2 zeigt eine Vorrichtung 40 zur Durchführung einer Variante des anhand der Figuren 1A bis 1C erläuterten Verfahrensschritte. Bei dem mit der Vorrichtung 40 durchführbaren Verfahren wird zunächst ein kontinuierliches Glasband 10 hergestellt. Dazu wird in einem Schmelzaggregat 50 eine Glasschmelze 52 erzeugt, welche an einem Auslaß 53 austritt und durch Walzen 54 zu einem flachen Glasband 10 mit gegenüberliegenden Seiten 11, 12 ausgeformt wird. Alternativ kann das Herstellen des kontinuierlichen Glasbandes 10 auch durch Floaten einer Glasschmelze auf einem Zinnbad erfolgen.

Die Siliziumoxid-haltige Schicht 5 wird wie anhand von Fig. 1A erläutert, durch Hydrolyse einer Siliziumverbindung in einer oder mehreren durch Brenner 21 erzeugten Flammen 22 abgeschieden. Im Unterschied zur der anhand der Fig. 1A bis 1C erläuterten Ausführungsform der Erfindung wird hier jedoch die Schicht 5 nach dem Walzen auf der Seite 11 des kontinuierlichen Glasbands 10 abgeschieden.

Die Flamme 22 weist einen inneren reduzierenden Teil 23 und einen äußerem oxidierenden Teil 24 auf. Ebenso wie bei der anhand von Fig. 1A gezeigten flammpyrolytischen Beschichtung wird die Flamme 22 und/oder der Abstand der Substratoberfläche zum Brenner 21 so eingestellt, daß nur der oxidierende Teil der Flamme 22 das Substrat -hier dementsprechend das Glasband 10- überstreicht.

Zur Herstellung vereinzelter Substrate 1 werden anschließend Abschnitte mittels einer Abtrenneinrichtung 58 abgetrennt. Das Abtrennen kann beispielsweise durch Anritzen des Glasbands 10 und Abknacken erfolgen. Anschließend wird mittels einer Druckeinrichtung 56 auf dem Glasband 10 die Dekorfarbe 9 aufgedruckt. Die Druckeinrichtung 56 kann beispielsweise eine Siebdruck-Einrichtung sein. Ebenso kann ein Auftrag auch durch elektrostatischem Auftrag, insbesondere auch elektrophotographisch, durch Übertragung eines Abziehbildes, Aufsprühen oder Aufspritzen erfolgen. Die vereinzelten Substrate 1 mit der flammpyrolytisch abgeschiedenen Schicht 5 und der aufgedruckten Dekorfarbe 9 werden dann in einem Keramisierungsofen 30 keramisiert, wobei gleichzeitig das Dekor eingebrannt wird.

Gemäß einer weiteren Ausführungsform der Erfindung wird die Dekorfarbe vor dem Abscheiden der Siliziumoxid-haltigen Schicht aufgebracht, so daß die Siliziumoxid-haltige Schicht sowohl die Dekorfarbe, als auch die übrige Oberfläche des Substrats bedeckt. Um diese Ausführungsform des erfindungsgemäßen Verfahrens durchzuführen, kann bei der in Fig. 2 dargestellten Vorrichtung beispielsweise die Anordnung der Druckeinrichtung 56 und der Brenner 21 vertauscht werden.

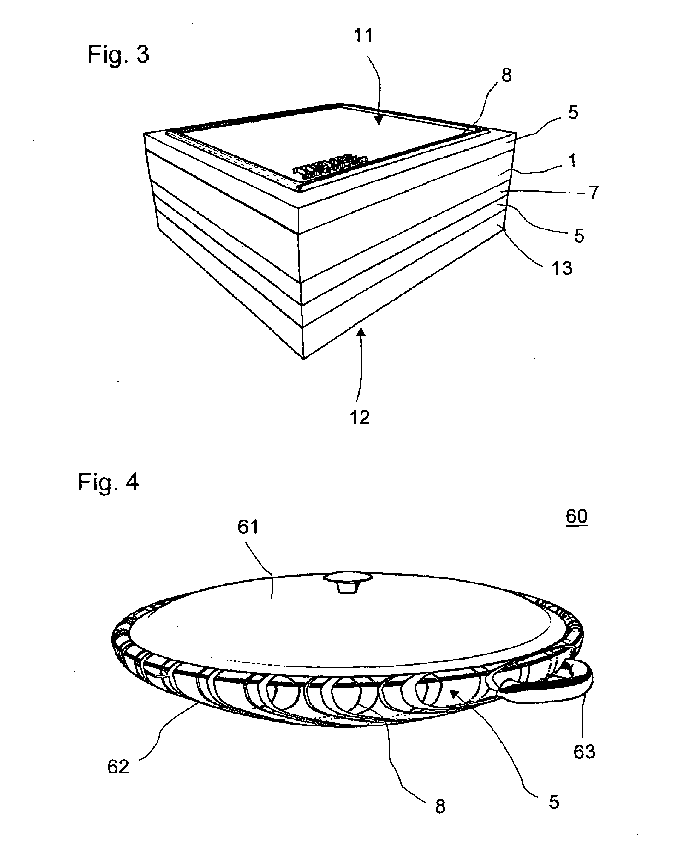

Fig. 3 zeigt eine Ausführungsform eines erfindungsgemäß herstellbaren Substrats mit zusätzlichen Funktionalschichten. Bei dieser Ausführungsform der Erfindung wird das Substrat auf einer Seite mit einer infrarotreflektierenden und/oder leitfähigen Zinnoxidschicht 7 beschichtet. Anschließend wird auf den Seiten 11, 12 des flachen Substrats 1, also beidseitig, eine erfindungsgemäße Siliziumoxid-haltige Schicht 5 flammpyrolytisch abgeschieden. Auf der Seite 11 dient die Schicht 5 als Diffusionssperre zur Vermeidung einer Hofbildung des auf diese Seite durch strukturierten Auftrag von Dekorfarbe und Einbrand der Farbe hergestellten Dekors 8.

Auf der Seite 12 des Substrats 1 dient die Schicht 5 als Haftvermittler für eine nachfolgend aufgebrachte hydrophobe Schicht 13. Durch die terminalen, nach außen weisenden OH-Gruppen einer erfindungsgemäß durch Flammpyrolyse hergestellten Siliziumoxid-haltigen Schicht 5 wird eine sehr gute Haftung der Schicht an die Zinnoxidschicht 7, sowie auch der hydrophoben Schicht 13 an die Schicht 5 hergestellt.

Das Herstellen der hydrophoben Schicht 13 erfolgt bevorzugt durch Auftrag eines silikathaltigen Sol-Gels, welchem eine hydrophobe Komponente zugesetzt ist. Als hydrophobe Komponente ist insbesondere Fluoralkylsilan geeignet, so daß in diesem Fall die Schicht 13 eine Fluoralkylsilan-haltige Silikatschicht ist.

Ein wie in Fig. 3 gezeigtes beschichtetes und dekoriertes Substrat ist beispielsweise als Backofenscheibe geeignet. Wird die Backofenscheibe so angeordnet, daß die Seite 12 mit der hydrophoben Schicht 13 und der infrarotreflektierenden Zinnoxidschicht 7 den Innenraum des Backofens begrenzt, so reduziert die Zinnoxidschicht 7 die Aufheizung der Scheibe. Zusätzlich läßt sich die Scheibe aufgrund der hydrophoben Beschichtung leicht reinigen, da das hydrophobe Fluoralkylsilan die Anhaftung von Schmutz verhindert.

Fig. 4 zeigt ein Beispiel für Koch- oder Eßgeschirr mit einem erfindungsgemäß herstellbaren dekorierten Substrat. Das in Fig. 4 dargestellte Ausführungsbeispiel der Erfindung zeigt ein Gargefäß, im Speziellen einen Wok 60 mit einem Unterteil 62, am Unterteil 62 befestigten Griffen 63 und einem Deckel 61. Das Unterteil 62 ist erfindungsgemäß flammpyrolytisch mit einer Siliziumoxid-haltigen Schicht 5 versehen. Auf der Schicht 5 ist wie bei den vorhergehenden Beispielen ein Dekor 8 durch Auftrag von Dekorfarbe und Einbrennen des Dekors hergestellt. Dabei bietet es sich wiederum an, das Einbrennen der Dekorfarbe durch das Tempern des Unterteils 62 für die Keramisierung vorzunehmen.

Selbstverständlich kann auch der Deckel 61 aus Glaskeramik gefertigt sein und ein erfindungsgemäß aufgebrachtes Dekor aufweisen.

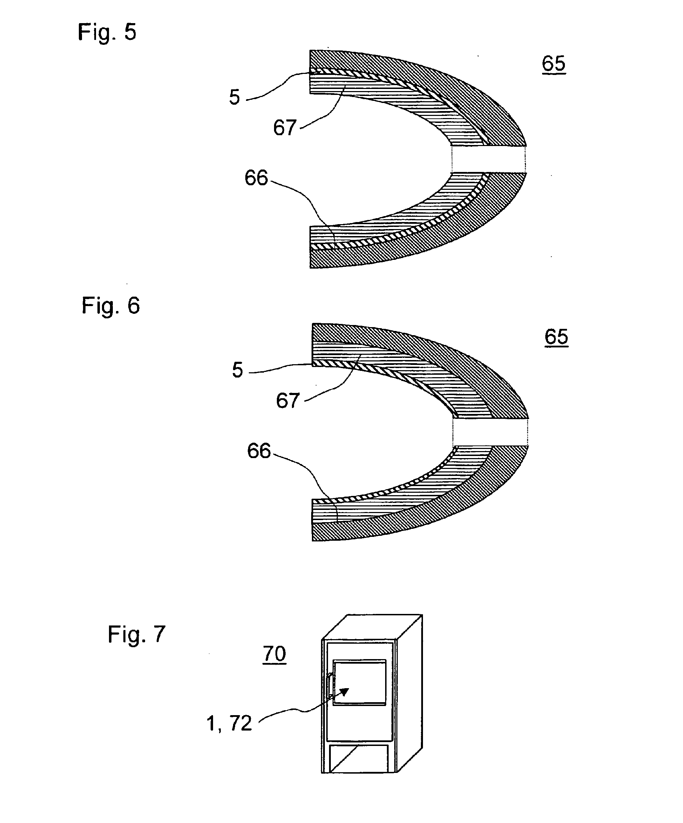

Die Fig. 5 und 6 zeigen zwei Varianten weiterer Anwendungsbeispiele der Erfindung. In beiden Figuren sind Glaskeramik-Reflektoren 65 dargestellt, wie sie insbesondere zur Lichtreflexion von Hochleistungslampen mit einer Leistung von über 200 Watt eingesetzt werden. Die Glaskeramik-Reflektoren 65 weisen auf der gewölbten Reflektorinnenseite 66, die als Reflexionsoberfläche für ein davor angeordnetes Leuchtmittel vorgesehen ist, jeweils Reflexionsbeschichtungen 67 auf. Zusätzlich ist diese Seite 66 des Reflektors in beiden Varianten jeweils mit einer flammpyrolytischen Siliziumoxid-haltigen Schicht 5 beschichtet. Die Herstellung der Schicht 5 erfolgt dabei analog zu den vorstehend erläuterten Beispielen durch Überstreichen der Innenseite 66 der Kalotte mit einer Flamme und Hydrolyse einer der Flamme zugesetzten Siliziumverbindung.

Bei der in Fig. 5 dargestellten Variante ist die Reflexionsbeschichtung 67 auf der vorher abgeschiedenen flammpyrolytischen Schicht 5 aufgebracht, während bei dem in Fig. 6 gezeigten Beispiel die Schicht 5 auf der Reflexionsbeschichtung 67 abgeschieden ist.

Bei diesem Beispiel kann die Schicht 5 auch bereits vor der Keramisierung des Grünglas-Substrats aufgebracht werden. In beiden Fällen dient die Schicht 5 als Barriere gegen die bei der enormen Temperaturbelastung des Reflektors sonst auftretenden Diffusionsprozesse, welche auf längere Sicht die optische Anmutung des Reflektors verändern können. Auch auf der Außenseite des Reflektors 65 kann eine Schicht 5 aufgebracht werden. Insbesondere können auf der Innenseite 66 und/oder auf der Außenseite Dekore vorhanden sein, die wie oben beschrieben erfindungsgemäß unter Verwendung einer flammpyrolytischen Schicht 5 als Diffusionssperre hergestellt werden.

Fig. 7 zeigt ein weiteres Beispiel eines Produkts mit einem erfindungsgemäßen Glaskeramik-Artikel. Ein Kaminofen 70 weist eine erfindungsgemäßes Glaskeramik-Substrat 1 als Kaminsichtscheibe 72 auf. Die Innenseite des Substrats 1, beziehungsweise der Kaminsichtscheibe 72 ist dabei erfindungsgemäß wie beispielsweise anhand von Fig. 1A dargestellt, mit einer flammpyrolytischen Siliziumoxid-haltigen Schicht 5 beschichtet. Die Siliziumoxid-haltige Schicht dient hier als Diffusionsbarriere oder Sperrschicht, um das Eindringen von im Innenraum entstehenden Verbrennungsprodukten in die Kaminsichtscheibe 72 zu verhindern oder zumindest zu verlangsamen. Insbesondere bei der Verbrennung von schwefelhaltigen Verbrennungsprodukten -Holz oder fossile Brennstoffe, wie Erdgas oder Erdöl- kommt es zur Bildung von Schwefeloxiden, welche die Glaskeramik der Sichtscheibe 72 korrodieren können.

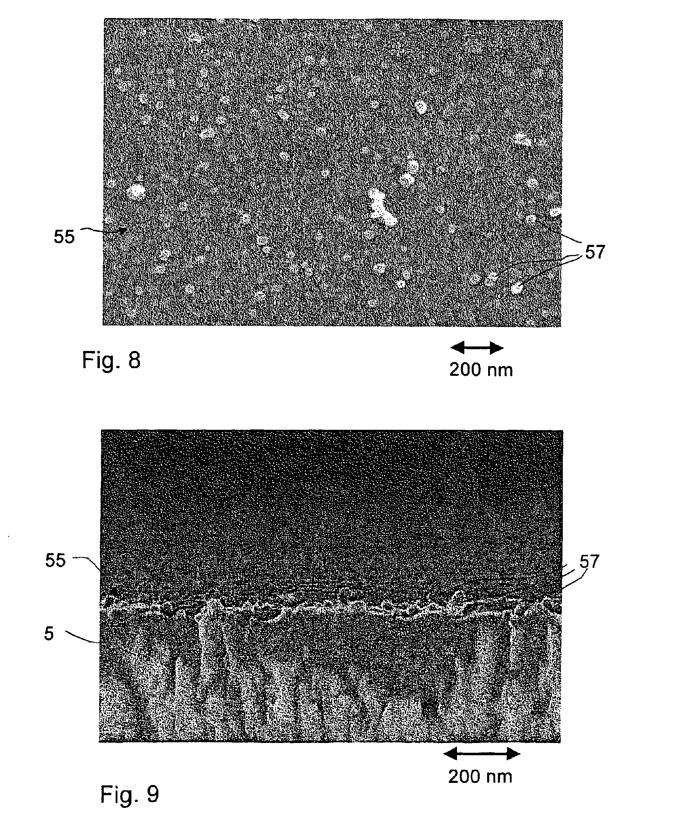

In den Fig. 8 und 9 sind rastelelektronenmikroskopische Aufnahmen von einem mit einer flammpyrolytisch abgeschiedenen Schicht beschichteten Glas-Substrats für eine nachfolgende Keramisierung dargestellt. Dabei zeigt Fig. 8 die beschichtete Oberfläche in Aufsicht und Fig. 9 eine Aufnahme einer Bruchkante des beschichteten Substrats. Die Vergrößerung dieser Aufnahmen ist anhand der unter den Bildern gezeigten Maßstabsbalken zu entnehmen. Die in Fig. 8 gezeigte Aufsicht auf die Oberfläche der flammpyrolytischen Schicht wurde mit einer Beschleunigungsspannung von 5 kV mit 200000-facher Vergrößerung aufgenommen. Das in Fig. 9 gezeigte Bild wurde mit 300000-facher Vergrößerung ebenfalls mit einer Beschleunigungsspannung von 5 kV aufgenommen.

Beide Bilder zeigen, daß die Oberfläche 55 der flammpyrolytischen Schicht 5 insgesamt eine körnige Struktur mit Siliziumoxid-haltigen Körnern 57 aufweist. Die Körner ragen dabei aus der Oberfläche der dichten Schicht 5 heraus, beziehungsweise sind auf dieser Oberfläche angeordnet. Von den in den Aufnahmen erkennbaren Körnern weisen mehr als 90 % einen Durchmesser kleiner als 80 Nanometer, sogar kleiner als 60 Nanometer auf. Überwiegend ist in Aufsicht ein Durchmesser bis 40 Nanometern zu beobachten. Aufgrund dieser feinkörnigen Oberflächenstruktur kann eine besonders große Oberfläche mit optisch aufgrund der geringen Größe der Körner nicht auffälliger Struktur erzielt werden. Die große Oberfläche in Verbindung mit den an der Oberfläche der Siliziumoxid-haltigen Schicht 5 zumindest in frisch abgeschiedenem Zustand in hoher Dichte vorhandenen OH-Gruppen sorgt für eine besonders gute Haftung nachfolgend aufgebrachter Materialien, wie etwa der Dekorfarbe oder weiteren Schichten. Nach der Keramisierung zeigt sich im allgemeinen eine Abflachung der Körner 57, so daß eine wellige Oberflächenstruktur der Schicht 5 erhalten wird. Manchmal sind die Partikel oder Körner 57 dabei aber auch nach der Keramisierung zu sehen.

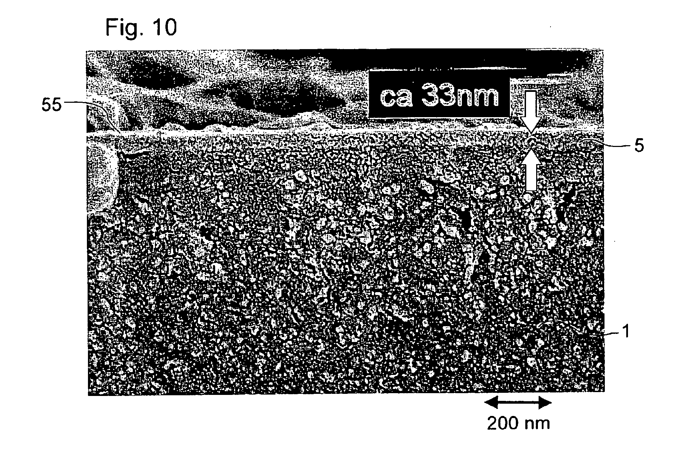

Eine rasterelektronenmikroskopische Aufnahme der Kante eines Substrats 1 mit einer Siliziumoxid-haltigen Schicht 5 nach der Keramisierung ist in Fig. 10 dargestellt. Das Bild wurde mit einer Beschleunigungsspannung von 10 kV und 350000-facher Vergrößerung aufgenommen. Auf der Oberfläche des Substrats ist die etwa 33 Nanometer dicke Siliziumoxid-haltige Schicht 5 zu erkennen. Nach der Keramisierung ist die Struktur der Oberfläche 55 nicht mehr so auffällig, eine wellige Struktur nach der Keramisierung ist allerdings noch vorhanden und sichtbar, auch sind einige Partikel im Hintergrund noch zu sehen.

## Patentansprüche

1. Verfahren zur Herstellung eines dekoriertenGlaskeramik-Substrats, bei welchem ein Glassubstrat (1) hergestellt oder bereitgestellt, auf dem Substrat (1) eine Siliziumoxid-haltige Schicht (5) abgeschieden, auf der Siliziumoxid-haltigen Schicht (5) Dekorfarbe (9) aufgebracht, die Dekorfarbe (9) eingebrannt und das Glassubstrat (1) keramisiert wird,
**dadurch gekennzeichnet, daß**
die Siliziumoxid-haltige Schicht (5) durch Überstreichen zumindest eines Bereiches der Oberfläche des Substrats (1) mit einer Flamme (22) und Hydrolyse einer der Flamme zugesetzten Siliziumverbindung flammpyrolytisch abgeschieden wird, und daß mit der flammpyrolytischen Abscheidung eine Siliziumoxid-haltige Schicht (5) erzeugt wird, die eine wirksame Diffusionsbarriere gegen eine Hofbildung in der Umgebung des Dekors bildet.

2. Verfahren zur Herstellung eines dekoriertenGlaskeramik-Substrats, bei welchem ein Glassubstrat (1) hergestellt oder bereitgestellt, auf dem Substrat (1) Dekorfarbe (9) aufgebracht, auf der mit dem Dekor versehenen Oberfläche eine Siliziumoxid-haltige Schicht (5) abgeschieden, die Dekorfarbe (9) eingebrannt und das Glassubstrat (1) keramisiert wird,
**dadurch gekennzeichnet, daß**
die Siliziumoxid-haltige Schicht (5) durch Überstreichen zumindest eines Bereiches der Oberfläche des Substrats (1) mit einer Flamme (22) und Hydrolyse einer der Flamme zugesetzten Siliziumverbindung flammpyrolytisch abgeschieden wird.

3. Verfahren gemäß Anspruch 1 oder 2, **dadurch gekennzeichnet, daß** das Einbrennen des Dekors durch ein Keramisieren des Substrats (1) erfolgt.

4. Verfahren gemäß einem der vorstehenden Ansprüche, **dadurch gekennzeichnet, daß** das Auftragen der Dekorfarbe (9) durch Aufdrucken, elektrostatischen, elektrophotographischen Auftrag, Übertragung eines Abziehbildes, Aufsprühen oder Aufspritzen erfolgt.

5. Verfahren gemäß einem der vorstehenden Ansprüche, **dadurch gekennzeichnet, daß** als Siliziumverbindung zumindest eine der Substanzen
- Hexamethyldisiloxan (HMDSO),
- Hexamethyldisilazan (HMDSN),
- Tetraethoxysilan,
verwendet wird.

6. Verfahren gemäß einem der vorstehenden Ansprüche, **dadurch gekennzeichnet, daß** ein Brenngas mit zumindest einer der Komponenten Wasserstoff, Methan, Propan, Butan zur Erzeugung der Flamme verwendet wird.

7. Verfahren gemäß einem der vorstehenden Ansprüche, bei welchem eine Flamme mit einem oxidierenden und einem reduzierenden Teil erzeugt und das Substrat (1) zur Abscheidung der Siliziumoxid-haltigen Schicht (5) nur mit dem oxidierenden Teil überstrichen wird.

8. Verfahren gemäß einem der vorstehenden Ansprüche, **dadurch gekennzeichnet, daß** ein flaches Substrat (1) beidseitig flammpyrolytisch mit einer Siliziumoxid-haltigen Schicht (5) beschichtet wird.

9. Verfahren gemäß einen der vorstehenden Ansprüche, **dadurch gekennzeichnet, daß** das Substrat (1) zusätzlich mit einer infrarotreflektierenden Schicht beschichtet wird.

10. Verfahren gemäß Anspruch 9, **dadurch gekennzeichnet, daß** das Substrat (1) mit einer Zinnoxidschicht als infrarotreflektierender Schicht, auch einer mit Fluor dotierten Zinnoxidschicht als infrarotreflektierender Schicht, beschichtet wird.

11. Verfahren gemäß einem der vorstehenden Ansprüche, **dadurch gekennzeichnet, daß** die Siliziumoxid-haltige Schicht (5) mit einer Schichtdicke von 2 bis 100 Nanometern, bevorzugt 4 bis 40 Nanometern, besonders bevorzugt höchstens 20 Nanometern abgeschieden wird.

12. Verfahren gemäß einem der vorstehenden Ansprüche, **dadurch gekennzeichnet, daß** ein Teilbereich der Siliziumoxid-haltigen Schicht (5) mit einer hydrophoben Beschichtung beschichtet wird.

13. Verfahren gemäß Anspruch 12, **dadurch gekennzeichnet, daß** ein Teilbereich der Siliziumoxid-haltigen Schicht (5) mit einer Fluoralkylsilan-haltigen Sol-Gel-Schicht beschichtet wird.

14. Verfahren gemäß einem der vorstehenden Ansprüche, **dadurch gekennzeichnet, daß** das Herstellen des Glassubstrats (1) das Herstellen eines kontinuierlichen Glasbandes (10) durch Floaten umfaßt.

15. Verfahren gemäß einem der vorstehenden Ansprüche, **dadurch gekennzeichnet, daß** das Herstellen des Glassubstrats (1) das Herstellen eines kontinuierlichen Glasbandes (10) durch Walzen umfaßt.

16. Verfahren gemäß einem der Ansprüche 14 oder 15, **dadurch gekennzeichnet, daß** das Abscheiden der Siliziumoxid-haltigen Schicht (5) das Abscheiden nach dem Walzen oder Floaten auf dem Glasband (10) umfaßt.

17. Verfahren gemäß einem der vorstehenden Ansprüche, **dadurch gekennzeichnet, daß** das Herstellen eines Glassubstrats (1) das Abtrennen eines Abschnitts von einem kontinuierlich hergestellten Glasband umfaßt.

18. Verfahren gemäß Anspruch 17, **dadurch gekennzeichnet, daß** das Abscheiden der Siliziumoxid-haltigen Schicht (5) das Abscheiden einer Siliziumoxid-haltigen Schicht auf dem durch Abtrennen hergestellten vereinzelten Substrat umfaßt.

19. Verfahren zur Herstellung eines Glaskeramik-Artikels, insbesondere eines Glaskeramik-Kochfelds, einer Glaskeramik-Sichtscheibe oder eines Glaskeramik-Reflektors, gemäß einem der Ansprüche 1 bis 18, **dadurch gekennzeichnet, daß** auf zumindest einer Seite des Substrats des Artikels oder des Grünglas-Substrats eine Siliziumoxid-haltige Barriereschicht durch Überstreichen mit einer Flamme und Hydrolyse einer der Flamme zugesetzten Siliziumverbindung flammpyrolytisch abgeschieden wird.

20. Verfahren gemäß einem der vorstehenden Ansprüche, **dadurch gekennzeichnet, daß** mit der flammpyrolytischen Abscheidung eine körnige Oberflächenstruktur der Siliziumoxid-haltigen Schicht (5) mit auf der Oberfläche einer dichten Schicht angeordneten Siliziumoxid-Körnern mit einem Durchmesser bis 80 Nanometer, vorzugsweise bis 60 Nanometer erzeugt wird.

21. Glaskeramiksubstrat, insbesondere herstellbar gemäß einem der vorstehenden Ansprüche, welches mit einem Dekor aus eingebrannter Dekorfarbe (9) ausgestattet ist, wobei das Dekor auf einer flammpyrolytischen, als Diffusionsbarriere gegen eine Hofbildung in der Umgebung des Dekors wirkenden Siliziumoxid-haltigen Schicht (5) auf dem Substrat aufgebracht ist, **dadurch gekennzeichnet, daß** die Siliziumoxidhaltige Schicht (5) eine körnige oder wellige Oberfläche mit auf der Schicht angeordneten Siliziumoxidhaltigen-Körnern mit einem Durchmesser bis 80 Nanometern, vorzugsweise bis 60 Nanometern aufweist.

22. Glaskeramiksubstrat, insbesondere herstellbar mit einem Verfahren gemäß einem der vorstehenden Ansprüche, welches mit einem Dekor aus eingebrannter Dekorfarbe (9) ausgestattet ist, wobei das Dekor von mit einer flammpyrolytischen Siliziumoxid-haltigen Schicht (5) bedeckten Bereichen der Substratoberfläche umgeben ist, **dadurch gekennzeichnet, daß** die Siliziumoxidhaltige Schicht (5) eine körnige oder wellige Oberfläche mit auf der Schicht angeordneten Siliziumoxidhaltigen-Körnern mit einem Durchmesser bis 80 Nanometern, vorzugsweise bis 60 Nanometern aufweist.

23. Glaskeramik-Substrat gemäß einem der vorstehenden Ansprüche, **dadurch gekennzeichnet, daß** die Siliziumoxid-haltige Schicht (5) eine Schichtdicke von 2 bis 100 Nanometern, bevorzugt 4 bis 40 Nanometern, besonders bevorzugt höchstens 20 Nanometern aufweist.

24. Glaskeramik-Substrat gemäß einem der vorstehenden Ansprüche, **gekennzeichnet durch** eine hydrophobe Beschichtung auf zumindest einem Teilbereich der Siliziumoxid-haltigen Schicht (5).

25. Glaskeramik-Substrat gemäß Anspruch 24, **dadurch gekennzeichnet, daß** die hydrophobe Beschichtung eine Fluoralkylsilan-haltige Silikatschicht umfaßt.

26. Glaskeramik-Substrat gemäß einem der vorstehenden Ansprüche, **gekennzeichnet durch** eine Zinnoxidschicht.

27. Erzeugnis, umfassend ein Glaskeramik-Substrat gemäß einem der Ansprüche 21 bis 26 , wobei das Erzeugnis ein Kochfeld oder eine Backofenscheibe oder ein Back- Koch- oder Gargefäß, insbesondere einem Wok, oder Eßgeschirr, oder einer Scheibe eines Kühlmöbels, oder ein Glaskeramik-Reflektor, oder eine Glaskeramik-Sichtscheibe ist.

28. Zwischenprodukt zur Herstellung eines Glaskeramik-Artikels gemäß einem der vorstehenden Ansprüche, umfassend ein Grünglas-Substrat und eine darauf abgeschiedene flammpyrolytische Siliziumoxid-haltige Schicht (5), **dadurch gekennzeichnet, daß** die Siliziumoxidhaltige Schicht (5) eine körnige oder wellige Oberfläche mit auf der Schicht angeordneten Siliziumoxidhaltigen-Körnern mit einem Durchmesser bis 80 Nanometern, vorzugsweise bis 60 Nanometern aufweist.

## Claims

1. Method for producing a decorated glass ceramic substrate, wherein a glass substrate (1) is produced or provided, a layer (5) containing silicon oxide is deposited on the substrate (1), decorative colour (9) is applied to the silicon oxide-containing layer (5), the decorative colour (9) is burned in and the glass substrate (1) is ceramicised, **characterised in that**
the silicon oxide-containing layer (5) is deposited by means of a flame-pyrolytic process by sweeping over at least one region of the surface of the substrate (1) with a flame (22) and hydrolysis of a silicon compound which is subjected to the flame, and that
a silicon oxide-containing layer (5) is produced by means of the flame-pyrolytic deposition, the said layer forming an effective diffusion barrier to prevent an aureole forming around the decoration.

2. Method for producing a decorated glass ceramic substrate, wherein a glass substrate (1) is produced or provided, decorative colour (9) is applied to the substrate (1), a silicon oxide-containing layer (5) is deposited on the surface which is provided with the decoration, the decorative colour (9) is burned in and the glass substrate (1) is ceramicised,
**characterised in that**
the silicon oxide-containing layer (5) is deposited by means of a flame-pyrolytic process by sweeping over at least one region of the surface of the substrate (1) with a flame (22) and hydrolysis of a silicon compound which is subjected to the flame.

3. Method as claimed in claim 1 or 2, **characterised in that** the decoration is burned in by ceramicising the substrate (1).

4. Method as claimed in any one of the preceding claims, **characterised in that** the decorative colour (9) is applied by means of printing, electrostatic, electrophotographic application, transferring a decal picture, spraying or sputtering.

5. Method as claimed in any one of the preceding claims, **characterised in that** at least one of the substances:
- hexamethyldisiloxane (HMDSO)
- hexamethyldisilazane (HMDSN)
- tetraethoxysilane
is used as the silicon compound.

6. Method as claimed in any one of the preceding claims, **characterised in that** a burnable gas with at least one of the components: hydrogen, methane, propane, butane, is used to produce the flame.

7. Method as claimed in any one of the preceding claims, wherein a flame is produced using an oxidizing and a reducing part and the substrate (1) is swept over only with the oxidizing part for depositing the silicon oxide-containing layer (5).

8. Method as claimed in any one of the preceding claims, **characterised in that** a flat substrate (1) is coated on both sides with a silicon oxide-containing layer (5) by means of a flame-pyrolytic process.

9. Method as claimed in any one of the preceding claims, **characterised in that** the substrate (1) is coated additionally with an infrared-reflecting layer.

10. Method as claimed in claim 9, **characterised in that** the substrate (1) is coated with a tin oxide layer as the infrared-reflecting layer and also with a tin oxide layer, which is doped with fluorine, as the infrared-reflecting layer.

11. Method as claimed in any one of the preceding claims, **characterised in that** the silicon oxide-containing layer (5) is deposited with a layer thickness of 2 to 100 nanometres, preferably 4 to 40 nanometres, especially preferred a maximum 20 nanometres.

12. Method as claimed in any one of the preceding claims, **characterised in that** a partial region of the silicon oxide-containing layer (5) is coated with a hydrophobic coating.

13. Method as claimed in claim 12, **characterised in that** a partial region of the silicon oxide-containing layer (5) is coated with a sol-gel layer which contains fluoroalkylsilane.

14. Method as claimed in any one of the preceding claims, **characterised in that** the production of the glass substrate (1) comprises the production of a continuous glass strip (10) by means of a floating process.

15. Method as claimed in any one of the preceding claims, **characterised in that** the production of the glass substrate (1) comprises the production of a continuous glass strip (10) by means of a rolling process.

16. Method as claimed in any one of claims 14 or 15, **characterised in that** the process of depositing the silicon oxide-containing layer (5) comprises deposition on the glass strip (10) following the rolling or floating process.

17. Method as claimed in any one of the preceding claims, **characterised in that** the production of a glass substrate (1) comprises separating a section from a continuously-produced glass strip.

18. Method as claimed in claim 17, **characterised in that** the process of depositing the silicon oxide-containing layer (5) comprises depositing a silicon oxide-containing layer on the separated substrate which has been produced by means of separation.

19. Method for producing a glass ceramic article, in particular a glass ceramic hob, a glass ceramic inspection window or a glass ceramic reflector as claimed in any one of claims 1 to 18, **characterised in that** a silicon oxide-containing barrier layer is deposited by means of a flame-pyrolytic process on at least one side of the substrate of the article or of the green glass substrate by sweeping over said substrate with a flame and hydrolysis of a silicon compound subjected to the flame.

20. Method as claimed in any one of the preceding claims, **characterised in that** by means of the flame-pyrolytic depositing process a grainy surface structure of the silicon oxide-containing layer (5) is produced with silicon oxide grains which have a diameter up to 80 nanometres, preferably up to 60 nanometres., and are disposed on the surface of a compact layer.

21. Glass ceramic substrate, in particular which can be produced as claimed in any one of the preceding claims, which substrate is provided with a decoration inn a decorative colour (9) which is burned in, wherein the decoration is applied to the substrate on a flame-pyrolytic, silicon oxide-containing layer (5) which acts as a diffusion barrier to prevent an aureole forming around the decoration, **characterised in that** the silicon oxide-containing layer (5) comprises a grainy or wavy surface with silicon oxide-containing grains which are disposed on the layer and have a diameter of up to 80 nanometres, preferably up to 60 nanometres.

22. Glass ceramic substrate, in particular which can be produced using a method as claimed in any one of the preceding claims, which substrate is provided with a decoration in a decorative colour (9) which is burned in, wherein the decoration is surrounded by regions of the substrate surface which are covered by a flame-pyrolytic, silicon oxide-containing layer (5), **characterised in that** the silicon oxide-containing layer (5) comprises a grainy or wavy surface with silicon oxide-containing grains which are disposed on the layer and have a diameter of up to 80 nanometres, preferably up to 60 nanometres.

23. Glass ceramic substrate as claimed in any one of the preceding claims, **characterised in that** the silicon oxide-containing layer (5) comprises a layer thickness of 2 to 100 nanometres, preferably 4 to 40 nanometres, especially preferred a maximum 20 nanometres.

24. Glass ceramic substrate as claimed in any one of the preceding claims, **characterised by** a hydrophobic coating on at least one partial region of the silicon oxide-containing layer (5).

25. Glass ceramic substrate as claimed in claim 24, **characterised in that** the hydrophobic coating comprises a fluoroalkylsilane-containing silicate layer.

26. Glass ceramic substrate as claimed in any one of the preceding claims, **characterised by** a tin oxide layer.

27. Product comprising a glass ceramic substrate as claimed in any one of the claims 21 to 26, wherein the product is a hob or an oven window or a baking, boiling or cooking vessel, in particular a wok, or plates and dishes, or a window in a refrigeration unit, or a glass ceramic reflector, or a glass ceramic inspection window.

28. Semi-finished product for producing a glass ceramic article as claimed in any one of the preceding claims, comprising a green glass substrate and a flame-pyrolytic, silicon oxide-containing layer (5) deposited thereon, **characterised in that** the silicon oxide-containing layer (5) comprises a grainy or wavy surface with silicon oxide-containing grains which are disposed on the layer and have a diameter of up to 80 nanometres, preferably up to 60 nanometres,

## Revendications

1. Procédé pour fabriquer un substrat en vitrocéramique décoré, dans lequel un substrat en verre (1) est fabriqué ou mis à disposition, une couche (5) contenant de l'oxyde de silicium est déposée sur le substrat (1), de la peinture de décoration (9) est appliquée sur la couche (5) contenant de l'oxyde de silicium, la peinture de décoration (9) est cuite et le substrat en verre (1) est céramisé,
**caractérisé en ce que**
la couche (5) contenant de l'oxyde de silicium est déposée par pyrolyse à la flamme par passage d'une flamme (22) sur au moins une zone de la surface du substrat (1) et hydrolyse d'un composé de silicium additionné à la flamme, et **en ce qu'**une couche (5) contenant de l'oxyde de silicium est générée avec le dépôt par pyrolyse à la flamme, laquelle couche forme une barrière de diffusion efficace contre une formation de halo dans l'environnement du décor.

2. Procédé pour la fabrication d'un substrat en vitrocéramique décoré, dans lequel un substrat en verre (1) est fabriqué ou mis à disposition, de la peinture de décoration (9) est appliquée sur le substrat (1), une couche (5) contenant de l'oxyde de silicium est déposée sur la surface dotée du décor, la peinture de décoration (9) est cuite et le substrat en verre (1) est céramisé,
**caractérisé en ce que**
la couche (5) contenant de l'oxyde de silicium est déposée par pyrolyse à la flamme par passage d'une flamme (22) sur au moins une zone de la surface du substrat (1) et hydrolyse d'un composé de silicium additionné à la flamme.

3. Procédé selon la revendication 1 ou 2, **caractérisé en ce que** la cuisson du décor s'effectue par une céramisation du substrat (1).

4. Procédé selon l'une quelconque des revendications précédentes, **caractérisé en ce que** l'application de la peinture de décoration (9) s'effectue par impression, application électrostatique, application électrophotographique, transmission d'une image à décalquer, application par pulvérisation ou application par projection.

5. Procédé selon l'une quelconque des revendications précédentes, **caractérisé en ce qu'**on utilise comme composé de silicium au moins l'une des substances suivantes
- hexaméthyldisiloxane (HMDSO),
- hexaméthyldisilazane (HMDSN),
- tétraéthoxysilane.

6. Procédé selon l'une quelconque des revendications précédentes, **caractérisé en ce qu'**un gaz de combustion est utilisé avec au moins l'un des composants suivants hydrogène, méthane, propane, butane pour générer la flamme.

7. Procédé selon l'une quelconque des revendications précédentes, dans lequel une flamme est générée avec une partie oxydante et une partie réductrice et le substrat (1) n'est enduit qu'avec la partie oxydante pour le dépôt de la couche (5) contenant de l'oxyde de silicium.

8. Procédé selon l'une quelconque des revendications précédentes, **caractérisé en ce qu'**un substrat (1) plat est recouvert des deux côtés par pyrolyse à la flamme avec une couche (5) contenant de l'oxyde de silicium.

9. Procédé selon l'une quelconque des revendications précédentes, **caractérisé en ce que** le substrat (1) est recouvert en supplément avec une couche réfléchissante à l'infrarouge.

10. Procédé selon la revendication 9, **caractérisé en ce que** le substrat (1) est recouvert avec une couche dioxyde d'étain comme couche réfléchissante à l'infrarouge, également avec une couche d'oxyde d'étain dopée avec du fluor comme couche réfléchissante à l'infrarouge.

11. Procédé selon l'une quelconque des revendications précédentes, **caractérisé en ce que** la couche (5) contenant de l'oxyde de silicium est déposée avec une épaisseur de couche de 2 à 100 nanomètres, de préférence 4 à 40 nanomètres, avec une préférence particulière au maximum 20 nanomètres.

12. Procédé selon l'une quelconque des revendications précédentes, **caractérisé en ce qu'**une zone partielle de la couche (5) contenant de l'oxyde de silicium est recouverte avec un revêtement hydrophobe.

13. Procédé selon la revendication 12, **caractérisé en ce qu'**une zone partielle de la couche (5) contenant de l'oxyde de silicium est recouverte avec une couche sol-gel contenant du fluoralkylsilane.

14. Procédé selon l'une quelconque des revendications précédentes, **caractérisé en ce que** la fabrication du substrat en verre (1) comprend la fabrication d'une bande de verre (10) continue par flottation.

15. Procédé selon l'une quelconque des revendications précédentes, **caractérisé en ce que** la fabrication du substrat en verre (1) comprend la fabrication d'une bande de verre (10) continue par laminage.

16. Procédé selon l'une des revendications 14 et 15, **caractérisé en ce que** le dépôt de la couche (5) contenant de l'oxyde de silicium comprend le dépôt après le laminage ou la flottation sur la bande de verre (10).

17. Procédé selon l'une quelconque des revendications précédentes, **caractérisé en ce que** la fabrication d'un substrat en verre (1) comprend la séparation d'une partie d'une bande de verre fabriquée de façon continue.

18. Procédé selon la revendication 17, **caractérisé en ce que** le dépôt de la couche (5) contenant de l'oxyde de silicium comprend le dépôt d'une couche contenant de l'oxyde de silicium sur le substrat isolé et fabriqué par séparation.

19. Procédé pour fabriquer un article en vitrocéramique, en particulier une plaque de cuisson en vitrocéramique, une vitre de regard en vitrocéramique ou un réflecteur en vitrocéramique, selon l'une quelconque des revendications 1 à 18, **caractérisé en ce qu'**une couche de barrière contenant de l'oxyde de silicium est déposée sur au moins un côté du substrat de l'article ou du substrat en verre vert par pyrolyse à la flamme par passage d'une flamme et hydrolyse d'un composé de silicium ajouté à la flamme.

20. Procédé selon l'une quelconque des revendications précédentes, **caractérisé en ce qu'**une structure de surface granuleuse de la couche (5) contenant de l'oxyde de silicium avec des grains d'oxyde de silicium disposés sur la surface d'une couche dense et présentant un diamètre allant jusqu'à 80 nanomètres, de préférence jusqu'à 60 nanomètres, est générée avec le dépôt par pyrolyse à la flamme.

21. Substrat en vitrocéramique, en particulier pouvant être fabriqué selon l'une quelconque des revendications précédentes, qui est équipé d'un décor à base d'une peinture de décoration (9) cuite, le décor étant appliqué sur le substrat sur une couche (5) contenant de l'oxyde de silicium déposée par pyrolyse à la flamme, agissant comme barrière de diffusion contre une formation d'un halo dans l'environnement du décor,
**caractérisé en ce que** la couche (5) contenant de l'oxyde de silicium présente une surface granuleuse ou ondulée avec des grains contenant de l'oxyde de silicium, disposés sur la couche et présentant un diamètre allant jusqu'à 80 nanomètres, de préférence jusqu'à 60 nanomètres.

22. Substrat en vitrocéramique, en particulier pouvant être fabriqué avec un procédé selon l'une quelconque des revendications précédentes, qui est équipé d'un décor à base de peinture de décoration (9) cuite, le décor étant entouré de zones, recouvertes avec une couche (5) contenant de l'oxyde de silicium et déposée par pyrolyse à la flamme, de la surface de substrat, **caractérisé en ce que** la couche (5) contenant de l'oxyde de silicium présente une surface granuleuse ou ondulée avec des grains contenant de l'oxyde de silicium, disposés sur la couche et présentant un diamètre allant jusqu'à 80 nanomètres, de préférence jusqu'à 60 nanomètres.

23. Substrat en vitrocéramique selon l'une quelconque des revendications précédentes, **caractérisé en ce que** la couche (5) contenant de l'oxyde de silicium présente une épaisseur de couche allant de 2 à 100 nanomètres, de préférence de 4 à 40 nanomètres, avec une préférence particulière au maximum 20 nanomètres.

24. Substrat en vitrocéramique selon l'une quelconque des revendications précédentes, **caractérisé par** un revêtement hydrophobe sur au moins une zone partielle de la couche (5) contenant de l'oxyde de silicium.

25. Substrat en vitrocéramique selon la revendication 24, **caractérisé en ce que** le revêtement hydrophobe comprend une couche de silicate contenant du fluoralkylsilane.

26. Substrat en vitrocéramique selon l'une quelconque des revendications précédentes, **caractérisé par** une couche d'oxyde d'étain.

27. Produit, comprenant un substrat en vitrocéramique selon l'une quelconque des revendications 21 à 26, le produit étant une plaque de cuisson ou une vitre de four ou un récipient de cuisson, en particulier un wok, ou une gamelle, ou une vitre d'un meuble réfrigérant, ou un réflecteur en vitrocéramique, ou une vitre de regard en vitrocéramique.

28. Produit intermédiaire pour fabriquer un article en vitrocéramique, selon l'une quelconque des revendications précédentes, comprenant un substrat en verre vert et une couche (5) contenant de l'oxyde de silicium et déposée dessus par pyrolyse à la flamme, **caractérisé en ce que** la couche (5) contenant de l'oxyde de silicium présente une surface granuleuse ou ondulée avec des grains contenant de l'oxyde de silicium disposés sur la couche et présentant un diamètre allant jusqu'à 80 nanomètres, de préférence jusqu'à 60 nanomètres.
